# EUROPEAN PATENT APPLICATION

(11) **EP 3 799 230 A1**
(43) Date of publication of application: **31.03.2021**
(21) Application number: 20207909.1
(22) Date of filing: 16.02.2018
(51) Int. Cl.: H01S 5/024, H01S 5/40, H01S 5/00, H01S 5/022, G02B 27/09

(54) **LASER OSCILLATION DEVICE AND LASER MACHINING APPARATUS**

(30) Priority: 22.05.2017 JP 2017101124
(62) Divisional of application: 18805906.7
(71) Applicant: Panasonic Intellectual Property Management Co., Ltd., Osaka-shi, Osaka 540-6207 (JP)
(72) Inventor: MOCHIYAMA, Tomohiro, Osaka, 540-6207 (JP); RYUDO, Makoto, Osaka, 540-6207 (JP); INOUE, Keita, Osaka, 540-6207 (JP)
(74) Representative: Vigand, Philippe

(57) **Abstract**

A laser oscillation device (1) includes a plurality of laser modules (10,11) configured to emit light beams; a beam multiplexer configured to combine the light beams emitted from the laser modules (10,11); and a power supply configured to supply power to the laser modules (10,11). The laser modules each include a plurality of laser diodes (40); a cooling plate (41) configured to cool the laser diodes (40); a pipe configured to carry a coolant to the cooling plate; a pressure sensor (27) and a flow sensor (28) configured to detect the pressure and the flow, respectively, of the coolant flowing through the pipe; and an adjustment mechanism (25) configured to adjust the pressure and the flow of the coolant based on the value of the pressure sensor (27) and the value of the flow sensor (28).

## Description

### TECHNICAL FIELD

The present disclosure relates to a laser oscillation device and a laser machining apparatus that are mainly used for cutting and welding.

### BACKGROUND ART

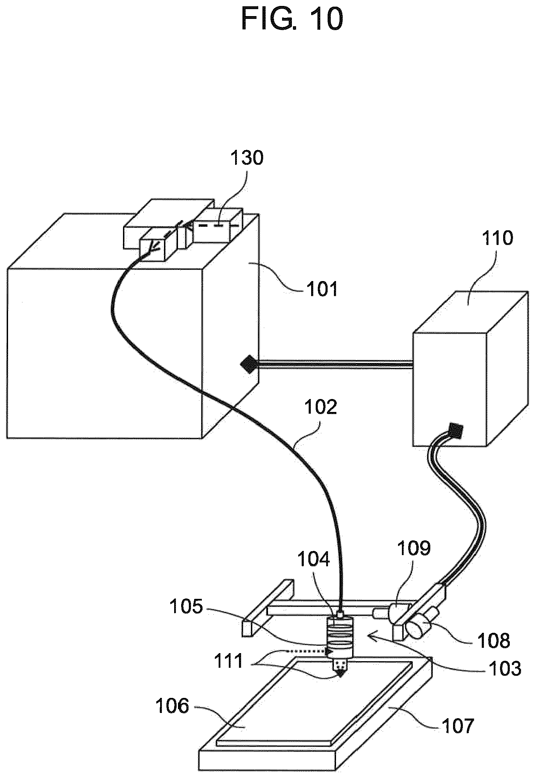

FIG. 10 shows a schematic configuration of a laser machining apparatus for cutting sheet metal. The apparatus includes laser oscillation device 101, machining head 103, machining table 107, and laser controller 110.

Laser oscillation device 101 emits laser beam 130, which propagates along process fiber 102 to machining head 103 connected to the emission side of process fiber 102.

Machining head 103 includes collimator lens 104 and condenser lens 105. Laser beam 130 is focused as a high density energy beam by condenser lens 105 onto workpiece 106 so as to cut workpiece 106.

Workpiece 106 is fixed on machining table 107. Machining head 103 is driven by X-axis motor 108 or Y-axis motor 109 so as to move relatively with respect to workpiece 106, thereby forming workpiece 106 into a predetermined shape.

Laser controller 110 controls laser oscillation device 101, X-axis motor 108, and Y-axis motor 109 in synchronization with each other. Device 101 supplies assist gas 111 such as nitrogen gas (N₂) or oxygen gas (O₂) according to the type of workpiece 106 while workpiece 106 is machined.

Typical laser machining apparatuses for sheet metal include a laser light source such as a carbon dioxide gas (CO₂) laser oscillator, a YAG laser oscillator, or a fiber laser oscillator. Fiber laser oscillators are superior in optical quality and oscillation efficiency to YAG laser oscillators. Because of these advantages, laser machining apparatuses including a fiber laser oscillator are widely used for industry, particularly for machining sheet metal (e.g., cutting or welding).

Patent Literature 1 discloses a semiconductor laser module including a semiconductor laser and a cooling heat sink for cooling the semiconductor laser.

The cooling heat sink includes a water path inside and two holes as the inlet and outlet of the coolant. The base of the semiconductor laser module has two through-holes corresponding to the holes of the cooling heat sink. Furthermore, there is provided an O ring at the joint of the holes of the cooling heat sink and the through-holes of the base. The base has a screw at the midpoint of the two through-holes so that the cooling heat sink can be sandwiched between the base and the presser plate.

### Citation List

### Patent Literature

PTL 1: Japanese Unexamined Patent Application Publication No. 2016-21452

### SUMMARY

In recent years, direct diode laser (DDL) machining apparatuses have been developed, which include as a laser light source a DDL oscillator. A DDL machining apparatus includes a resonator including various optical element such as diffraction grating. The optical elements are used to superimpose the multiple-wavelength laser beams emitted from the laser diodes and to transmit the resultant beam to the machining head along a transmission fiber. As described above, the laser beam emitted from the end face of the transmission fiber is focused on the workpiece after passing through the collimator lens and the condenser lens.

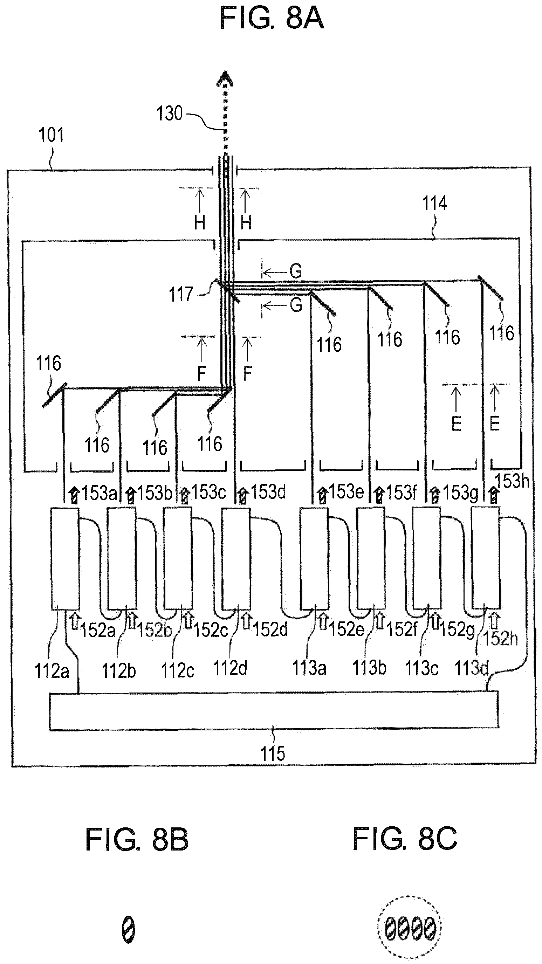

FIG. 8A shows a schematic diagram of a laser oscillation device used in a laser machining apparatus for cutting sheet metal.

DDL oscillator (laser oscillation device) 101 includes laser modules 112a-112d and 113a-113d, beam multiplexer 114, and power supply 115.

Each of laser modules 112a-112d and 113a-113d includes a plurality of laser diodes for emitting laser beams. The laser beams emitted from these laser modules are each combined into single laser beams. The intensity of the laser beams is controlled by the power supplied from power supply 115 connected to the laser modules. The maximum intensity of the laser modules is about 1 kW.

The laser beams emitted from laser modules 112a-112d and 113a-113d are received by beam multiplexer 114 including reflective mirrors 116 and beam splitter 117. When received by beam multiplexer 114, the laser beams from laser modules 112a-112d and those from laser modules 113a-113d are polarized perpendicular to each other. For example, the former laser beams can be p-polarized and the latter laser beams can be s-polarized.

The laser beams received by beam multiplexer 114 are spatially combined by reflective mirrors 116 individually. In this case, reflective mirrors 116 are disposed to avoid interference between the laser beams.

As shown in FIG. 8B, the laser beam received from each laser module has an elliptic cross section (when taken along line E-E of FIG. 8A) due to characteristics of laser diodes. As shown in FIG. 8C, after spatially combined, the beams have a cross section of the same number of ellipsoids as the laser beams (when taken along line F-F or line G-G of FIG. 8A).

The spatially combined individual laser beams are then polarization combined by beam splitter 117. Since polarization combination is applied to the polarized beams perpendicular to each other, these optical axes can be aligned.

Hence, the cross section of the laser beams remains the same after the polarization combination (when taken along line H-H of FIG. 8A). Laser oscillation device 101 emits the beam obtained by the polarization combination as laser beam 130.

Laser diodes, which generate significant heat during optical resonance, are generally water-cooled. FIG. 8A shows inlet coolants 152a to 152d for cooling the laser diodes of laser modules 112a-112d, respectively, and outlet coolants 153a to 153d for cooling the laser diodes of laser modules 113a-113d, respectively.

The example of FIG. 8A has eight laser modules each with 1 kW, and therefore, laser oscillation device 101 has a maximum output power of 8 kW. However, the output power of laser oscillation device 101 can be increased or decreased by increasing or decreasing the number of laser modules as desired.

Laser modules 112a-112d and 113a-113d are connected in series with respect to power supply 115. Power supply 115 supplies an equal amount of current to each of laser modules 112a-112d and 113a-113d so as to regulate the intensity of laser beam 130. Thus, when, for example, to obtain an output power of 4 kW with the structure of FIG. 8A, eight laser modules can be driven at a power of 500 W, which is 50% of the maximum output power of 1 kW.

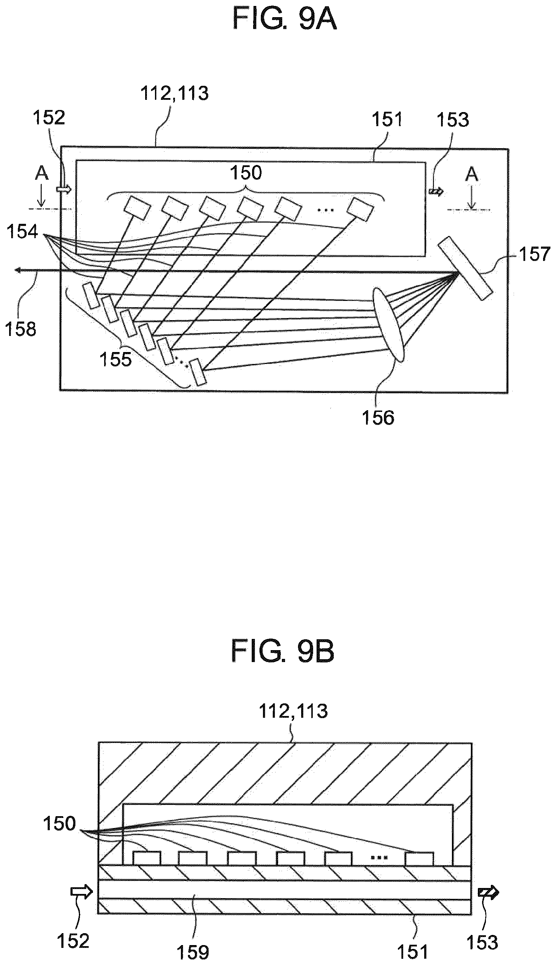

FIGS. 9A and 9B show the schematic internal structure of laser modules 112a-112d (also numbered as 112) and 113a-113d (also numbered as 113) shown in FIG. 8A. Laser modules 112 and 113 are formed of laser diodes 150 and optical elements that accomplish spectral beam combining of the multiple-wavelength laser beams.

Each laser module superimposes laser beams 154 having multiple-wavelengths λ1, λ2, λ3, ... λn all together using total-reflection mirrors 155, condenser lens 156, and diffraction grating 157. As a result, each laser module emits one laser beam 158. To achieve miniaturization, the laser modules perform optical resonance and the superimposing of laser beams 154 in a small space by using total-reflection mirrors 155.

Laser beams 158 emitted from laser modules 112a-112d and 113a-113d are polarization combined and spatially combined by beam multiplexer 114. The resultant laser beam 130 is used for machining such as cutting and welding.

Laser diodes require a cooling system because they generate significant heat during optical resonance.

The cooling system shown in Patent Literature 1 described above cools the plurality of laser diodes separately. Such a cooling system is very expensive when applied to the laser diodes separately.

This problem can be overcome by collectively cooling laser diodes 150 using the cooling system shown in FIG. 9B. To be more specific, laser diodes 150 composing the laser modules are placed on single cooling plate 151. Cooling plate 151 includes cooling path 159 to which a predetermined amount of water at a predetermined temperature is supplied. FIG. 9B shows pipe inlet coolant 152 and pipe output coolant 153.

One parameter to determine the performance to machine a workpiece is a beam quality. The beam quality of laser beams used for machining is generally expressed by a beam parameter product (BPP). The smaller the BPP, the smaller the focusing spot diameter, and consequently the focal depth of the laser beam is shorter. The greater the BPP, the greater the focusing spot diameter, and consequently the focal depth of the laser beam is longer. The value of the BPP depends on the alignment of the laser diodes as the light source and the optical elements after the laser beams are emitted from the laser diodes.

Therefore, the placement of the laser diodes, the placement of the optical elements, and their alignment are performed carefully. The laser diodes, which are placed on the cooling heat sink, are aligned particularly carefully when the cooling heat sink is filled with the same flow and pressure of water as will be actually used by the user.

However, the BPP can decrease with time, thus deteriorating the performance to machine the workpiece. One such example is the case that the conditions under which the user will actually supply the coolants to the laser oscillation device is different from the alignment conditions under which the laser oscillation device is manufactured. Another example is the case that the conditions under which the user supplies the coolants to the laser oscillation device has differed from the default conditions due to pipe clogging caused when the user has used the laser oscillation device for a long time.

The present disclosure provides a laser oscillation device and a laser machining apparatus both of which can ensure a stable BPP and maintain a stable machining performance.

The laser device of an aspect of the present disclosure includes a plurality of laser modules configured to emit light beams; a beam multiplexer configured to combine the light beams emitted from the plurality of laser modules; and a power supply configured to supply power to the plurality of laser modules. Each of the plurality of laser modules includes: a plurality of laser diodes; a cooling plate configured to cool the plurality of laser diodes; a pipe configured to carry a coolant to the cooling plate; a pressure sensor and a flow sensor configured to detect the pressure and the flow, respectively, of the coolant flowing through the pipe; and an adjustment mechanism configured to adjust the pressure and the flow of the coolant based on the value of the pressure sensor and the value the flow sensor.

In the aspect of the present disclosure, the pressure and other conditions of the coolant supplied to the cooling plate is adjustable. Hence, the present disclosure can provide a laser oscillation device and a laser machining apparatus both of which can ensure a stable BPP and maintain a stable machining performance.

### BRIEF DESCRIPTION OF DRAWINGS

FIG. 1A is a schematic diagram of a laser oscillation device of an exemplary embodiment of the present disclosure.
FIG. 1B is a sectional view of the laser beam taken along line E-E of FIG. 1A.
FIG. 1C is a sectional view of the laser beams taken along line F-F, line G-G, or line H-H of FIG. 1A.
FIG. 2A is a configuration diagram of laser modules incorporated into the laser oscillation device.
FIG. 2B is a sectional view of each laser module taken along line A-A of FIG. 2A.
FIG. 3 is a piping diagram for the coolants for the laser modules in the first exemplary embodiment.
FIG. 4 is a piping diagram for the coolants for the laser modules in a second exemplary embodiment.
FIG. 5 is a piping diagram for the coolants for the laser modules in a third exemplary embodiment.
FIG. 6 is a piping diagram for the coolants for the laser modules in a fourth exemplary embodiment.
FIG. 7 is a flowchart showing the operation procedure of the adjustor in the first exemplary embodiment.
FIG. 8A is a schematic diagram of a laser oscillation device.
FIG. 8B is a sectional view of the laser beam taken along line E-E of FIG. 8A.
FIG. 8C is a sectional view of the laser beams taken along line F-F, line G-G, or line H-H of FIG. 8A.
FIG. 9A is a configuration diagram of laser modules incorporated into the laser oscillation device.
FIG. 9B is a sectional view of each laser module taken along line A-A of FIG. 9A.
FIG. 10 is an overall schematic diagram of a well-known laser machining apparatus.

### DESCRIPTION OF EMBODIMENTS

Embodiments of a laser oscillation device and a laser machining apparatus, to both of which the art of the present disclosure has been applied will now be described with reference to the drawings.

### FIRST EXEMPLARY EMBODIMENT

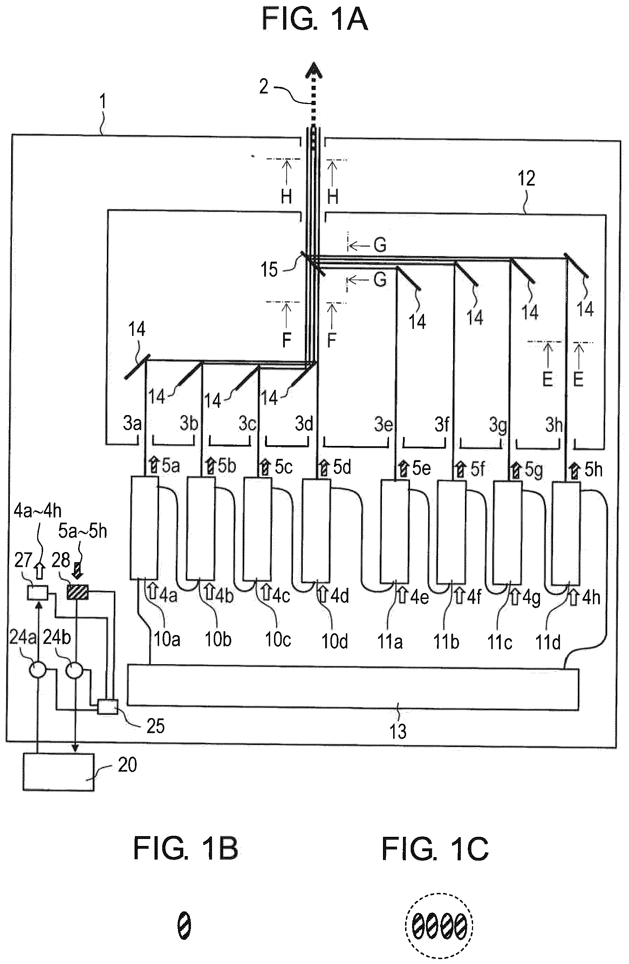

As shown in FIG. 1A, laser oscillation device 1 includes laser modules 10a-10d and 11a-11d, beam multiplexer 12, and power supply 13. Beam multiplexer 12 includes reflective mirrors 14 and beam splitter 15.

Each of laser modules 10a-10d and 11a-11d includes a plurality of laser diodes for emitting laser beams. The laser beams emitted from laser modules 10a-10d and 11a-11d are each combined into single laser beams 3a-3h, respectively. The intensity of laser beams 3a-3h is controlled by the power supplied from power supply 13 to laser modules 10a-10d and 11a-11d. The maximum intensity of these laser modules is about 1 kW.

Laser beams 3a-3h emitted from laser modules 10a-10d and 11a-11d are received by beam multiplexer 12. When received by beam multiplexer 12, the laser beams from laser modules 10a-10d and those from laser modules 11a-11d are polarized perpendicular to each other. For example, the former laser beams can be p-polarized and the latter laser beams can be s-polarized.

Laser beams 3a-3h received by beam multiplexer 12 are spatially combined by reflective mirrors 14 individually. In this case, reflective mirrors 14 are disposed to avoid interference between laser beams 3a-3h. As shown in FIG. 1B, which is a sectional view of the laser beam taken along line E-E of FIG. 1A, laser beams 3a-3h received from laser modules 10a-10d and 11a-11d have an elliptic cross section due to characteristics of laser diodes. Therefore, as shown in FIG. 1C, which is a sectional view of the laser beams taken along line F-F or line G-G of FIG. 1A, after spatially combined, the beams have a cross section of the same number of ellipsoids as the laser beams.

The spatially combined individual laser beams are then polarization combined by beam splitter 15. Since polarization combination is applied to the polarized beams perpendicular to each other, these optical axes can be aligned. Hence, the cross section of the laser beams remains the same after the polarization combination as shown in FIG. 1C taken along line H-H of FIG. 1A.

The beam obtained by polarization combination is emitted as laser beam 2 of laser oscillation device 1. Laser beam 2 has an outermost diameter shown by the broken line of FIG. 1C.

Laser modules 10a-10d and 11a-11d are connected in series with each other. Power source 13 supplies an equal amount of current to each of laser modules 10a-10d and 11a-11d so that these laser modules can emit the same power of laser beams. The present exemplary embodiment includes eight laser modules each with 1 kW, so that the maximum intensity of laser beam 2 is 8 kW. The number of the laser modules is not limited to eight and can be increased or decreased depending on the maximum power required to laser oscillation device 1.

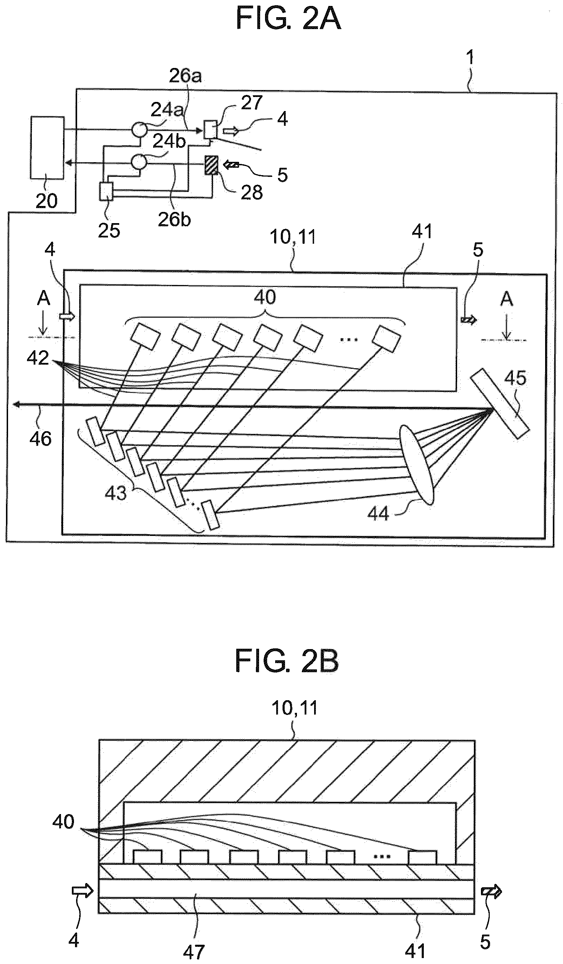

FIGS. 2A and 2B show the structure of either laser modules 10 (10a-10d) or laser modules 11 (11a-11d), both of which are incorporated into laser oscillation device 1. Laser oscillation device 1 shown in FIG. 2A includes one laser module only, but in reality, includes all of laser modules 10 and 11.

Each one of laser modules 10 (10a-10d) and 11 (11a-11d) includes laser diodes 40 and optical elements that accomplish spectral beam combining of the multiple-wavelength laser beams.

Each laser module superimposes laser beams 42 having multiple-wavelengths λ1, λ2, λ3, ... λn all together using total-reflection mirrors 43, condenser lens 44, and diffraction grating 45. As a result, each laser module emits one laser beam 46. To achieve miniaturization, the laser modules perform optical resonance and the superimposing of laser beams 42 in a small space by using total-reflection mirrors 43.

Laser beam 46 obtained by the superimposing is emitted from each of laser modules 10 and 11, and is polarization combined and spatially combined with the laser beams emitted from the other laser modules as described above. The resultant laser beam 2 (see FIG. 1A) is used for machining such as cutting and welding of a workpiece. Laser oscillation device 1 includes a cooling system for cooling laser diodes 40, which generate significant heat during optical resonance.

To be more specific, laser oscillation device 1 includes cooling plate 41, pipes 26a and 26b, pressure sensor 27, flow sensor 28, and adjustor 25. Cooling plate 41 cools laser diodes 40. Pipes 26a and 26b carry coolants to cooling path 47 of cooling plate 41. Pressure sensor 27 detects the pressure of water used as the coolants flowing through pipes 26a and 26b. Flow sensor 28 detects the flow of the water flowing through pipes 26a and 26b. Adjustor 25 automatically adjusts the pressure and flow of the coolants based on the values of pressure sensor 27 and flow sensor 28, respectively. The coolants are supplied from a coolant circulator (hereinafter, referred to as the chiller) 20, which is provided separately from laser oscillation device 1.

Chiller 20 constantly supplies the coolants kept at a predetermined temperature to laser oscillation device 1. Device 1 has regulating valve 24a and pressure sensor 27 on the inlet side of laser modules 10 and 11, and regulating valve 24b and flow sensor 28 on the outlet side of laser modules 10 and 11. Regulating valves 24a and 24b, pressure sensor 27, and flow sensor 28 are electrically connected to adjustor 25.

FIGS. 1A, 2A, and 2B show coolants 4a to 4h (abbreviated as "4" in FIGS. 2A and 2B) on the inlet side of laser modules 10a-10d and 11a-11d, respectively, in order to cool laser diodes 40, and coolants 5a to 5h (abbreviated as "5" in FIGS. 2A and 2B) on the outlet side of laser modules 10a-10d and 11a-11d, respectively.

Laser diodes 40 composing laser modules 10 and 11 are placed on cooling plate 41. Cooling plate 41 has, inside it, cooling path 47 for circulating the coolants. The coolants are kept at a constant temperature by chiller 20 so as to provide the cooling capacity determined by the specification.

Pressure sensor 27, flow sensor 28, and adjustor 25 together keep the coolants flowing through laser modules 10 and 11 at the same pressure and flow as those under the alignment conditions of laser diodes 40 determined when laser modules 10 and 11 are assembled.

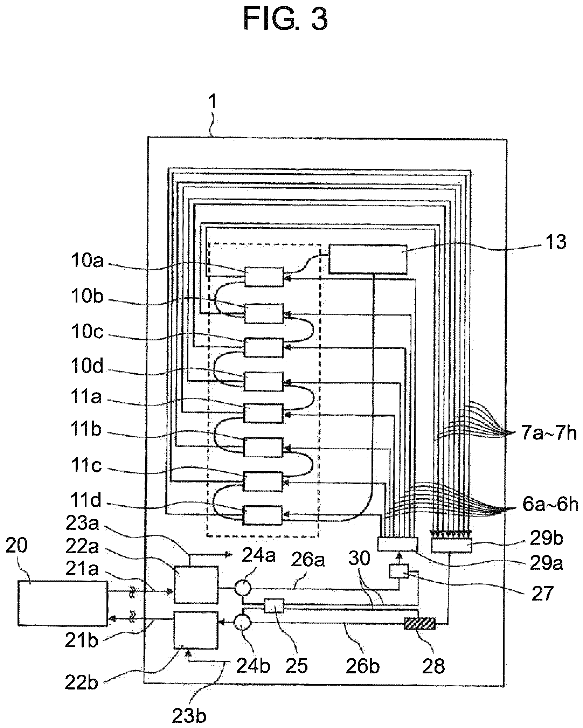

FIG. 3 shows pipes for cooling laser modules 10 and 11. Laser oscillation device 1 and chiller 20 are connected through hoses 21a and 21b. Eight laser modules 10a-10d and 11a-11d are connected to inlet manifold 29a through eight pipes 6a to 6h, respectively. Eight laser modules 10a-10d and 11a-11d are also connected to outlet manifold 29b through eight pipes 7a to 7h, respectively.

Laser oscillation device 1 further includes many heating elements besides laser modules 10a-10d and 11a-11d. These heating elements need to be cooled in order to operate the device stably. To achieve this, laser oscillation device 1 includes manifolds 22a and 22b on its proximal side. These manifolds are connected to chiller 20 so as to feed the coolants to the heating elements other than laser modules 10a-10d and 11a-11d.

The heating elements other than laser modules 10a-10d and 11a-11d are cooled by cooling channels 23a and 23b. Manifolds 29a and 22a are connected to each other through pipe 26a, whereas manifolds 29b and 22b are connected to each other through pipe 26b. Pipe 26a connecting manifolds 22a and 29a is connected to regulating valve 24a and pressure sensor 27 for monitoring the water pressure. Pipe 26b connecting manifolds 22b and 29b is connected to regulating valve 24b and flow sensor 28 for monitoring the flow of water flowing through pipe 26b.

Thus, pressure sensor 27 and flow sensor 28 are preferably disposed in pipes 26a and 26b, respectively, but can alternatively be disposed in other pipes. When manifolds 22a and 22b are provided, sensors 27 and 28 are preferably disposed at a position closer to laser modules 10a-10d and 11a-11d than a position closer to manifolds 22a and 22b.

Pressure sensor 27, flow sensor 28, and regulating valves 24a, 24b are connected to adjustor 25, which controls the opening degrees of the valves, through signal cable 30. Pressure sensor 27 and flow sensor 28 each have upper and lower thresholds in accordance with the specification of laser diodes 40. If either or both of the value of pressure sensor 27 and the value of flow sensor 28 exceed the upper or lower threshold, adjustor 25 calculates and adjusts the opening degrees of the valves so that the values fall within the thresholds. Adjustor 25 then transmits the calculated amount to regulating valves 24a and 24b, thereby feedback-controlling the opening degrees of the valves. Thus, the pressure and flow of the coolants flowing through cooling path 47 of cooling plate 41 for cooling laser diodes 40 can be automatically controlled within the specified range.

Adjustor 25 is a semiconductor integrated circuit including a storage unit, an input unit, a calculation unit, and an output unit. The storage unit stores the upper and lower thresholds and anomalous thresholds. The input unit receives signals from pressure sensor 27 and flow sensor 28. The calculation unit calculates and derives the amount to control regulating valves 24a and 24b. The output unit outputs control signals for driving regulating valves 24a and 24b. Thus, the adjustor 25 functions as an adjustment mechanism for adjusting the pressure and flow of the coolants based on the values of pressure sensor 27 and flow sensor 28, respectively.

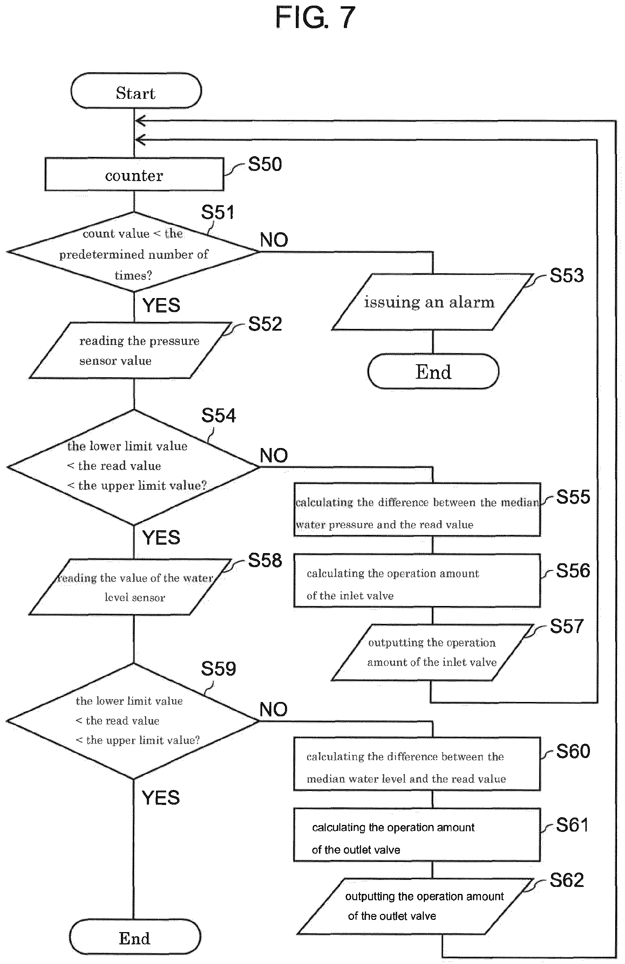

The operation of adjustor 25 for controlling regulating valves 24a and 24b will now be described in detail with reference to the flowchart of FIG. 7.

First, the counter indicating the number of process loops is incremented by one (S50). The number of loops is initially set to 0. If the counter value is smaller than the predetermined number of times (YES in S51), the process goes to Step S52 in which the value of pressure sensor 27 is read.

The value of the pressure sensor 27 for the coolants is read (S52) and is determined whether the value is within the upper and lower thresholds (S54). If the value is outside the thresholds (NO in S54), the difference between the median water pressure and the read value is calculated (S55). The difference is used to calculate the operation amount of regulating valve 24a on the inlet side of the laser modules (S56). The operation amount is sent to regulating valve 24a (S57). When Step S57 is over, the process returns to Step S50.

If the pressure on the inlet side of the laser modules is within the upper and lower thresholds (YES in S54), the value of flow sensor 28 is read (S58), and is determined whether the value is within the upper and lower thresholds. If the value is outside the thresholds (NO in S59), the difference between the median water level and the read value is calculated (S60). The difference is used to calculate the operation amount of regulating valve 24b on the outlet side of the laser modules (S61). The operation amount is sent to regulating valve 24b (S62).

If both the value read from pressure sensor 27 and the value read from flow sensor 28 fall within the upper and lower thresholds, the process is terminated. However, if the range is too large, the read values may not fall within the upper and lower thresholds no matter how many times the loop is repeated. Therefore, if the counter value of the number of loops is greater than the predetermined number of times (NO in S51), an alarm indicating that the regulation is disabled is issued (S53), and the counter value is reset to zero to terminate the process. In such cases, the maintenance staff is called to solve the problem.

For example, if clogging occurs between chiller 20 and the inlet of laser modules 10, 11, the water pressure decreases both on the inlet and outlet sides of the laser modules. In this case, adjustor 25 first opens regulating valve 24a on the inlet side, and then outputs a signal for making valve 24a on the inlet side have the median pressure (the median water pressure).

Adjustor 25 then opens regulating valve 24b on the outlet side so as to achieve the median flow (the median water level). After these adjustments, adjustor 25 again checks the sensors monitoring values (the values read from pressure sensor 27 and flow sensor 28). If the sensors monitoring values fall within the upper and lower thresholds, the adjustment operation is completed. Meanwhile, if the sensors monitoring values are still outside the thresholds, adjustor 25 repeats the adjustment operation of regulating valves 24a and 24b.

If clogging occurs between pressure sensor 27 and flow sensor 28, the pressure increases on the inlet side, and decreases on the outlet side of laser modules 10 and 11. In such cases, adjustor 25 first closes regulating valve 24a on the inlet side so as to make valve 24a have the median pressure. Adjustor 25 then opens regulating valve 24b on the outlet side so as to make valve 24b have the median flow. After these adjustments, adjustor 25 again checks the sensors monitoring values. If the sensors monitoring values fall within the upper and lower thresholds, the adjustment operation is completed. Meanwhile, if the sensors monitoring values are still outside the thresholds, adjustor 25 repeats the adjustment operation of regulating valves 24a and 24b.

If clogging occurs between the outlet of laser modules 10, 11 and chiller 20, the water pressure increases both on the inlet and outlet sides of laser modules 10 and 11. In this case, adjustor 25 first closes regulating valve 24a on the inlet side so as to make value 24a have the median pressure. Adjustor 25 then opens regulating valve 24b on the outlet side so as to make value 24b have the median flow.

After these adjustments, adjustor 25 again checks the sensors monitoring values. If the sensors monitoring values fall within the upper and lower thresholds, the adjustment operation is completed. Meanwhile, if the sensors monitoring values are still outside the thresholds, adjustor 25 repeats the adjustment operation of regulating valves 24a and 24b. In either case, if the sensors monitoring values do not fall within the specified range even after the loop is repeated a predetermined number of times, adjustor 25 issues an alarm signal.

The first exemplary embodiment described so far includes one pressure sensor and one flow sensor, but may alternatively include two or more pressure sensors and two or more flow sensors. Thus, laser oscillation device 1 can include laser modules 10 and 11, each of which includes the following: a plurality of laser diodes 40; cooling plate 41 for cooling laser diodes 40; pipes 26a and 26b for carrying coolants to cooling plate 41; pressure sensor 27 and flow sensor 28 for detecting the pressure and flow of the coolants flowing through pipes 26a and 26b, respectively; and an adjustment mechanism (adjustor 25) for automatically adjusting the pressure and flow of the coolants based on the values of pressure sensor 27 and flow sensor 28, respectively.

### SECOND EXEMPLARY EMBODIMENT

In the above-described first exemplary embodiment, laser modules 10 and 11 have at least one pressure sensor and at least one flow sensor. The flow of the coolants flowing through laser modules 10 and 11 is roughly in proportion to the difference between the pressure on the inlet side and the pressure on the outlet side of laser modules 10 and 11.

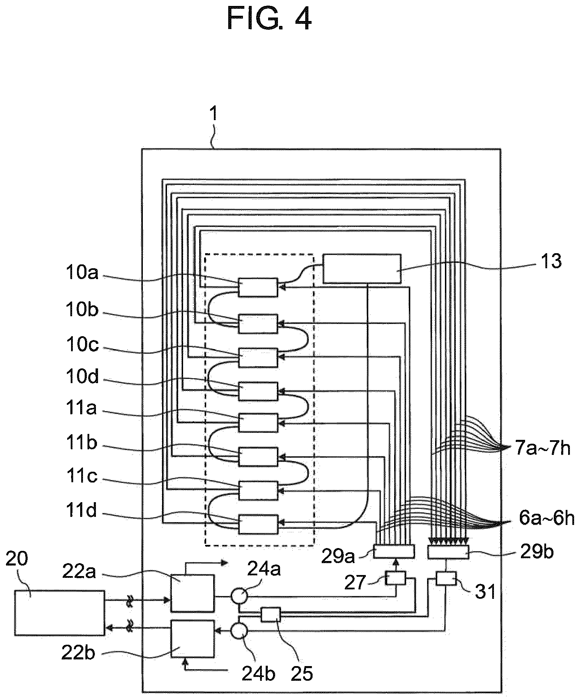

Hence, as shown in FIG. 4, flow sensor 28 can be replaced by pressure sensor 31. In other words, at least one pressure sensor can be disposed on each of the inlet and outlet sides of laser modules 10 and 11. In addition, the thresholds of each pressure sensor can be set to appropriate values.

Thus, laser modules 10 and 11 incorporated into laser oscillation device 1 can each include the following: a plurality of laser diodes 40; cooling plate 41 for cooling laser diodes 40; pipes 26a and 26b for carrying coolants to cooling plate 41; pressure sensor 27 disposed on the inlet side of pipe 26a, and pressure sensor 31 disposed on the outlet side of pipe 26b; and an adjustment mechanism (adjustor 25) for adjusting the pressure of the coolants based on the values of pressure sensors 27 and 31.

### THIRD EXEMPLARY EMBODIMENT

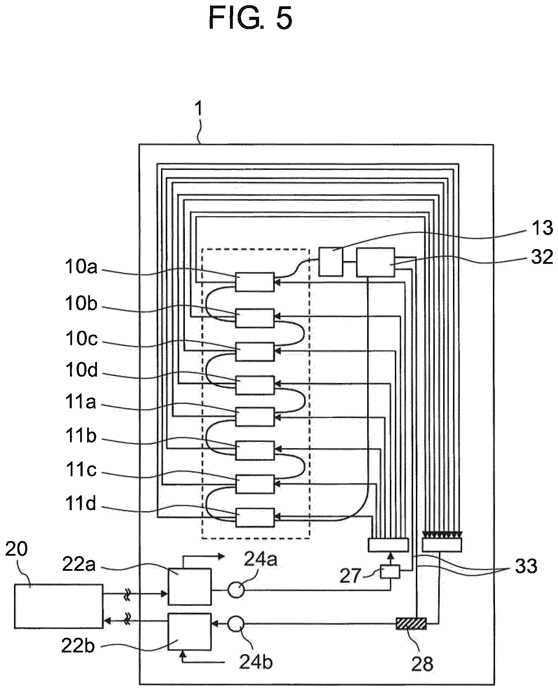

The pressure and flow of the coolants change over several thousands to several hundreds of thousands of hours due to clogging or other deterioration of the coolant pipes. As shown in FIG. 5, laser oscillation device 1 does not necessarily have to include adjustor 25 for automatically adjusting regulating valves 24a and 24b. Instead, laser oscillation device 1 can include power supply controller 32 for controlling power supply 13 which supplies power to laser modules 10a-10d and 11a-11d. Power source controller 32, pressure sensor 27, and flow sensor 28 are electrically connected to each other via signal cables 33. Power supply controller 32 can be configured to issue a warning or to stop power supply 13 when either or both of the value of pressure sensor 27 and the value of flow sensor 28 exceed the upper or lower threshold for fault detection.

In this case, too, the user can call the maintenance staff to have them adjust regulating valves 24a and 24b. Furthermore, it is possible to set two-step values as thresholds for fault detection; when the detected value exceeds the primary threshold, a warning can be issued, and when the detected value exceeds the secondary threshold, the power supply can be stopped.

The present exemplary embodiment does not include adjustor 25, but the art of the present disclosure is not limited to this structure. Laser oscillation device 1 can include adjustor 25. In this case, regulating valves 24a and 24b and adjustor 25 together optimize the pressure and flow of the coolants within the upper and lower thresholds in accordance with the specification of laser diodes 40. If either or both of the value of the pressure and the value of the flow of the coolants fall outside the predetermined range, power supply controller 32 issues a warning, or suspends power supply to laser modules 10 and 11. The predetermined range can be the same or greater than the upper and lower thresholds. Adjustor 25 can adjust the pressure and flow of the coolants based on the value of pressure sensor 27 and the value of flow sensor 28, respectively, in the same manner as in the first exemplary embodiment. Alternatively, adjustor 25 can adjust the pressure and flow of the coolants based on the values of pressure sensors 27 and 31 in the same manner as in the second exemplary embodiment.

### FOURTH EXEMPLARY EMBODIMENT

In the above described exemplary embodiments, a total of eight laser modules 10 and 11 are cooled by separate pipes; alternatively, however, laser modules 10 and 11 can share the same pipes.

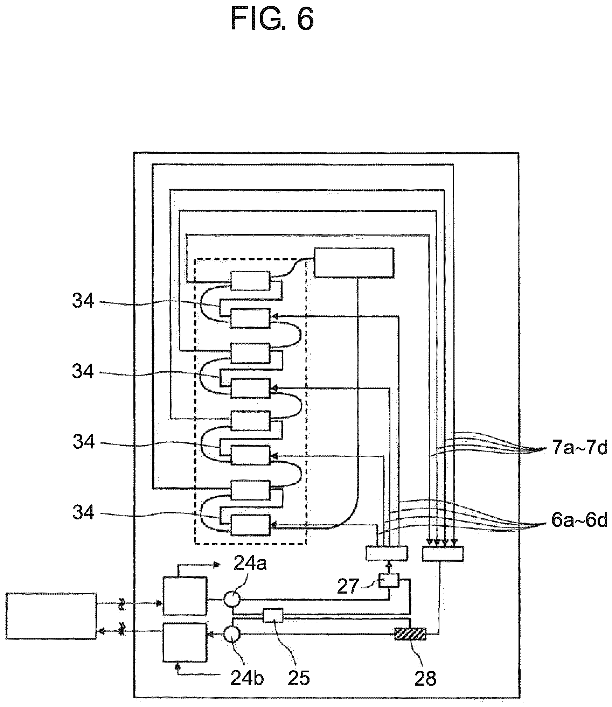

For example, as shown in FIG. 6, every two laser modules can be connected in series through pipes 34. In the example of FIG. 6, eight laser modules are cooled by four pipes 34. Thus, every two or more laser modules can be connected in series to be cooled. This example has effects similar to the above-mentioned exemplary embodiments when the opening degrees of regulating valves 24a and 24b are properly adjusted based on the values of pressure sensor 27 and flow sensor 28.

The laser machining apparatus of the present disclosure can be accomplished by using laser oscillation device 1 instead of well-known laser oscillation device 101 shown in FIG. 10.

The above-described exemplary embodiments are just examples of the present disclosure. It goes without saying that the specific structures of the components are not limited to the above-described examples and can be modified as long as the present disclosure can have the intended effects.

### INDUSTRIAL APPLICABILITY

The laser oscillation device and the laser machining apparatus of the present disclosure can ensure a stable BPP and maintain a stable machining performance by properly cooling the laser oscillation device.

### REFERENCE MARKS IN THE DRAWINGS

1 laser oscillation device
2 laser beam
3a-3h laser beam
4a-4h coolant on the inlet side of the laser module
5a-5h coolant on the outlet side of the laser module
6a-6h pipe
7a-7h pipe
10a-10d laser module
11a-11d laser module
12 beam multiplexer
13 power supply
14 reflective mirror
15 beam splitter
20 chiller
21a, 21b hose
22a, 22b manifold
23a, 23b cooling channel for cooling the components other than the laser modules
24a, 24b regulating valve
25 adjustor
26a, 26b pipe
27 pressure sensor
28 flow sensor
29a, 29b manifold
30 signal cable
31 pressure sensor
32 power supply controller
33 signal cable
34 pipe connecting laser modules
40 laser diode
41 cooling plate
42 laser beam
43 total-reflection mirror
44 condenser lens
45 diffraction grating
46 laser beam
47 cooling path

## Claims

1. A laser oscillation device comprising:
a plurality of laser modules configured to emit light beams;
a beam multiplexer configured to combine the light beams emitted from the plurality of laser modules; and
a power supply configured to supply power to the plurality of laser modules,
wherein
each of the plurality of laser modules includes:
a plurality of laser diodes;
a cooling plate configured to cool the plurality of laser diodes;
a pipe configured to carry a coolant to the cooling plate;
a pair of pressure sensors disposed, one on an inlet side and an other on an outlet side of the pipe, the pair of pressure sensors being configured to detect a pressure of the coolant flowing through the pipe; and
an adjustment mechanism configured to adjust the pressure of the coolant based on values of the pair of pressure sensors.

2. The laser oscillation device according to claim 1, further comprising a power supply controller configured to control the power supply,
wherein when either or both of the values of the pair of pressure sensors fall outside a predetermined range, the power supply controller either issues a warning or stops supplying power to the plurality of laser modules.

3. A laser machining apparatus comprising the laser oscillation device according to any one of claims 1 to 2.

4. A laser oscillation device comprising:
a plurality of laser modules configured to emit light beams;
a beam multiplexer configured to combine the light beams emitted from the plurality of laser modules;
a power supply configured to supply power to the plurality of laser modules; and
a power supply controller configured to control the power supply,
wherein
each of the plurality of laser modules includes:
a plurality of laser diodes;
a cooling plate configured to cool the plurality of laser diodes;
a pipe configured to carry a coolant to the cooling plate; and
a pair of pressure sensors disposed, one on an inlet side and an other on an outlet side of the pipe, the pair of pressure sensors being configured to detect a pressure of the coolant flowing through the pipe, and
when either or both of values of the pair of pressure sensors fall outside a predetermined range, the power supply controller either issues a warning or stops supplying power to the plurality of laser modules.
